(19) Europäisches Patentamt
European Patent Office
Office européen des brevets

(11) **EP 3 335 228 B1**

(12) **EUROPÄISCHE PATENTSCHRIFT**

(45) Veröffentlichungstag und Bekanntmachung des Hinweises auf die Patenterteilung:
**13.07.2022 Patentblatt 2022/28**

(21) Anmeldenummer: **16757151.2**

(22) Anmeldetag: **10.08.2016**

(51) Internationale Patentklassifikation (IPC):
***H01B 12/06*** (2006.01)

(52) Gemeinsame Patentklassifikation (CPC):
**H01B 12/06;** Y02E 40/60

(86) Internationale Anmeldenummer:
**PCT/EP2016/001368**

(87) Internationale Veröffentlichungsnummer:
**WO 2017/025189 (16.02.2017 Gazette 2017/07)**

(54) **SUPRALEITFÄHIGER LEITER UND VERWENDUNG DES SUPRALEITFÄHIGEN LEITERS**

SUPERCONDUCTING CONDUCTOR AND USE OF THE SUPERCONDUCTING CONDUCTOR

CONDUCTEUR APTE À LA SUPRACONDUCTION ET UTILISATION DU CONDUCTEUR APTE À LA SUPRACONDUCTION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.08.2015 DE 102015010636**

(43) Veröffentlichungstag der Anmeldung:
**20.06.2018 Patentblatt 2018/25**

(73) Patentinhaber: **Karlsruher Institut für Technologie 76131 Karlsruhe (DE)**

(72) Erfinder:
• **FIETZ, Walter**
**76344 Eggenstein-Leopoldshafen (DE)**
• **WOLF, Michael, J.**
**75177 Pforzheim (DE)**
• **HELLER, Reinhard**
**76887 Bad Bergzabern (DE)**

• **WEISS, Klaus-Peter**
**76297 Stutensee (DE)**

(74) Vertreter: **Müller-Boré & Partner Patentanwälte PartG mbB Friedenheimer Brücke 21 80639 München (DE)**

(56) Entgegenhaltungen:
JP-A- H09 223 418        US-A- 5 929 000
US-A1- 2010 099 570        US-B1- 6 271 474

• **WOLF MICHAEL J ET AL: "HTS CroCo: A Stacked HTS Conductor Optimized for High Currents and Long-Length Production", IEEE TRANSACTIONS ON APPLIED SUPERCONDUCTIVITY, IEEE SERVICE CENTER, LOS ALAMITOS, CA, US, Bd. 26, Nr. 2, 1. März 2016 (2016-03-01), Seiten 19-24, XP011608745, ISSN: 1051-8223, DOI: 10.1109/TASC.2016.2521323 [gefunden am 2016-03-01]**

**Beschreibung**

Die Erfindung betrifft einen supraleitfähigen Leiter sowie eine Verwendung des supraleitfähigen Leiters.

Supraleiter sind Materialien, deren elektrischer Widerstand unterhalb einer bestimmten Temperatur komplett verschwindet. Folglich haben Supraleiter keine elektrischen DC-Verluste, sofern sie bei genügend tiefen Temperaturen betrieben werden. Ein Leiter für den Stromtransport oder eine Spule aus solchen supraleitenden Materialien weist folglich keine DC-Verluste auf. Somit kann ein Strom über solch einen Leiter sehr effektiv übertragen werden. Insbesondere können mit supraleitenden Magneten hohe Magnetfelder sehr effizient erzeugt werden. Man unterscheidet Tieftemperatur- und Hochtemperatursupraleiter nach dem Wert der Temperatur des Phasenübergangs vom supraleitenden zum normalleitenden Zustand. Bei Tieftemperatursupraleitern liegt dieser typischerweise unter 30 K, bei Hochtemperatursupraleitern zum Teil sehr deutlich höher, z.B. über der Siedetemperatur des Stickstoffs (T = -196°C). Daher werden Hochtemperatur-Supraleiter (HTS) auch für weitergehende Anwendungen diskutiert, da - im Vergleich zu Tieftemperatursupraleitern - der Aufwand für die Kühlung deutlich reduziert ist. Dazu zählen u.a. die Energieübertragung, rotierende Maschinen, wie z.B. Generatoren, Motoren, etc., oder Magnete, z.B. für NMR oder Teilchenbeschleuniger.

Hochtemperatursupraleiter aus Seltenerd-Barium-Kupfer-Oxid-Materialien (engl. Rare Earth Barium Copper Oxide, kurz REBCO), sind im Hinblick auf die Feld- und Temperaturbereiche sowie auf die Stromdichte die derzeit auf dem Markt erhältlichen interessantesten HTS-Materialien. Allerdings werden diese in Form von dünnen Bändern hergestellt, bei denen der Supraleiter als dünne Schicht mit einer Dicke von ungefähr 1 $\mu$m auf ein Substrat aufgebracht wird, so dass ein Band mit einer typischen Dicke von 100 $\mu$m bei einer Breite im Millimeter-Bereich entsteht. Für diese flachen Bänder können keine klassischen Verseilungstechniken zur Herstellung von Kabeln hoher Stromtragfähigkeit angewandt werden, so dass neue Ansätze benötigt werden um aus den Supraleiterbändern elektrische Leiter bzw. Kabel für höhere Ströme zu fertigen.

Bei der Übertragung hoher elektrischer Leistungen durch Supraleiter müssen die Leiter entsprechend gekühlt werden. Insofern ist es wünschenswert, das zu kühlende Volumen möglichst klein zu halten, also hohe Stromdichten im Bündel bzw. Kabel zu erzielen. Eine hohe Leistungsdichte ist auch bei der Erzeugung hoher Felder in großen Magneten gewünscht. Gleichzeitig ist eine hohe mechanische Stabilität der Kabel nötig, z.B. im Hinblick auf mechanische Abstützung mit möglichst geringem Wärmeeintrag, thermischen Zyklen oder elektromagnetische Kräften.

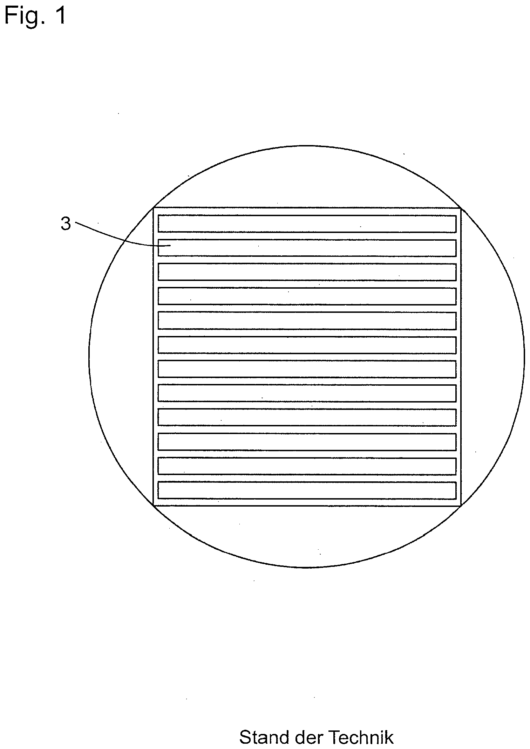

Aus der Druckschrift US 2010/0099570 A1 ist beispielsweise ein Supraleiterkabel bekannt, welches einen Stapel von supraleitfähigen Bändern mit rechteckigem Querschnitt aufweist. Ein derartiger herkömmlicher supraleitfähiger Leiter ist in der Figur 1 schematisch dargestellt.

Die Druckschrift JP H09 223418 A offenbart einen supraleitfähigen Oxid-Draht und ein Verfahren zu dessen Herstellung. Der supraleitfähige Draht umfasst eine Vielzahl von in einer Silber-Matrix eingebetteten BSCCO Supraleiter.

Die Druckschrift US 2010/099570 A1 offenbart ein Supraleiterkabel mit mehreren flachen bandförmigen Supraleiterbändern, die zu einem Stapel mit rechteckigem Querschnitt zusammengefügt sind, wobei der Stapel eine Verdrillung um eine Längsachse des Stapels aufweist.

Die Druckschrift US 5 929 000 A offenbart einen supraleitenden Oxid-Draht mit einer kreisförmigen Querschnittsform. Der supraleitende Draht besteht aus mehreren Filamenten, die sich in Form von Bändern entlang der Längsrichtung des Drahts erstrecken, und einer die Filamente bedeckenden Stabilisator-Matrix.

Die Druckschrift US 6 271 474 B1 offenbart einen Draht, der ein supraleitendes Oxidmaterial und eine das supraleitende Oxidmaterial bedeckende Stabilisator-Matrix aus Silber oder einer Silberlegierung enthält.

Es ist eine Aufgabe der vorliegenden Erfindung, einen supraleitfähigen Leiter bereitzustellen, der kompakt, mechanisch stabil und für hohe Stromdichten ausgelegt ist. Darüber hinaus ist es eine Aufgabe der vorliegenden Erfindung eine Verwendung des supraleitfähigen Leiters anzugeben.

Diese Aufgabe wird durch die Gegenstände der nebengeordneten Ansprüche gelöst. Vorteilhafte Ausführungsformen sind Gegenstand der Unteransprüche.

Ein erster unabhängiger Aspekt zur Lösung der Aufgabe betrifft einen supraleitfähigen Leiter, umfassend:

- eine Vielzahl von ersten leitfähigen Bändern, welche jeweils eine erste Breite aufweisen;
- eine Vielzahl von zweiten leitfähigen Bändern, welche jeweils eine zweite Breite aufweisen;

wobei sich die erste Breite von der zweiten Breite unterscheidet,

wobei die Vielzahl von ersten leitfähigen Bändern und/oder die Vielzahl von zweiten leitfähigen Bändern zumindest ein Supraleiterband umfasst,

wobei die Vielzahl von ersten leitfähigen Bändern und die Vielzahl von zweiten leitfähigen Bändern zu einem Bandstapel mit kreuzförmigem Querschnitt angeordnet bzw. gestapelt sind, und

wobei jeweils zwei in dem Bandstapel aufeinanderfolgende leitfähige Bänder miteinander verlötet sind, so dass aus dem Bandstapel ein Supraleiterkörper gebildet ist bzw. wird.

Unter einem leitfähigen bzw. elektrisch leitfähigen Band wird allgemein ein flaches, elektrisch leitfähiges Band verstanden, welches beispielsweise eine Dicke von etwa 100 $\mu$m und z.B. eine Breite von etwa 2 mm bis 12 mm aufweist. Die Länge eines leitfähigen Bandes kann je nach Anwendung z.B. 1 m bis 1 km oder auch mehr betragen. Ein leitfähiges Band kann insbesondere ein Metallband, wie z.B. ein Kupferband sein. Mit anderen Worten kann das leitfähige Band teilweise oder vollständig aus Metall, wie z.B. Kupfer gebildet sein. Ein leitfähiges Band kann aber auch supraleitfähig sein. Mit anderen Worten kann ein leitfähiges Band ein Supraleiterband sein.

Ein Supraleiterband ist ein Band, welches ein Substrat umfasst, auf das ein Supraleiter, insbesondere ein Hochtemperatur-Supraleiter wie z.B. REBCO, als dünne Schicht, beispielsweise mit einer Dicke von etwa 1 $\mu$m, aufgebracht ist. Das Substrat kann z.B. eine Dicke von etwa 100 $\mu$m aufweisen. Ein Supraleiterband hat somit beispielsweise ebenfalls eine Dicke von etwa 100 $\mu$m und kann z.B. eine Breite von etwa 2 mm bis 12 mm aufweisen. Die Länge eines Supraleiterbands kann je nach Anwendung z.B. 1 m bis 1 km oder auch mehr sein. Es versteht sich, dass aber auch andere Werte möglich sind. Bei den ersten und zweiten Supraleiterbändern handelt es sich vorzugsweise um Hochtemperatur-Supraleiterbänder.

Der supraleitfähige Leiter umfasst eine Vielzahl von ersten leitfähigen Bändern und eine Vielzahl von zweiten leitfähigen Bändern, wobei sich jeweils ein erstes leitfähiges Band von einem zweiten leitfähigen Band in der Breite unterscheidet. Jedes der ersten leitfähigen Bänder hat die gleiche Breite, nämlich eine erste Breite.

Entsprechend hat auch jedes der zweiten leitfähigen Bänder die gleiche Breite, nämlich eine zweite Breite, die sich von der ersten Breite unterscheidet.

Vorzugsweise umfasst die Vielzahl von ersten leitfähigen Bändern zumindest ein erstes Supraleiterband, welches die erste Breite aufweist. Vorzugsweise umfasst die Vielzahl von ersten leitfähigen Bändern zwei oder mehrere erste Supraleiterbänder mit jeweils der ersten Breite. Noch bevorzugter sind alle ersten leitfähigen Bänder erste Supraleiterbänder mit jeweils der ersten Breite.

Vorzugsweise umfasst die Vielzahl von zweiten leitfähigen Bändern zumindest ein zweites Supraleiterband, welches die zweite Breite aufweist. Vorzugsweise umfasst die Vielzahl von zweiten leitfähigen Bändern zwei oder mehrere zweite Supraleiterbänder mit jeweils der zweiten Breite. Noch bevorzugter sind alle zweiten leitfähigen Bänder zweite Supraleiterbänder mit jeweils einer zweiten Breite.

Insbesondere umfasst der supraleitfähige Leiter eine Vielzahl von ersten Supraleiterbändern und eine Vielzahl von zweiten Supraleiterbändern, wobei sich jeweils ein erstes Supraleiterband von einem zweiten Supraleiterband in der Breite unterscheidet. Jedes der ersten Supraleiterbänder hat die gleiche Breite, nämlich eine erste Breite. Entsprechend hat auch jedes der zweiten Supraleiterbänder die gleiche Breite, nämlich eine zweite Breite, die sich von der ersten Breite unterscheidet.

Als Breite eines leitfähigen Bandes bzw. Supraleiterbandes wird der Abstand gegenüberliegender End- bzw. Längskanten des Bandes verstanden, wobei sich die End- bzw. Längskanten entlang des Bandes erstrecken, d.h. den langen Kanten des Bands entsprechen. Die Breite des leitfähigen Bandes bzw. Supraleiterbandes ist stets kleiner als die Länge des leitfähigen Bandes bzw. Supraleiterbandes. Im Vergleich zur Breite und Länge des Supraleiterbandes wird unter der Dicke des Supraleiterbandes die Abmessung des Supraleiterbandes in Richtung des Substrat-Supraleiter-Übergangs verstanden.

Vorzugsweise umfasst der elektrische Leiter ausschließlich erste und zweite leitfähige Bänder, insbesondere Supraleiterbänder, d.h. leitfähige Bänder bzw. Supraleiterbänder mit der ersten Breite und leitfähige Bänder bzw. Supraleiterbänder mit der zweiten Breite. Mit anderen Worten umfasst der elektrische Leiter vorzugsweise keine leitfähigen Bänder bzw. Supraleiterbänder mit anderen Breiten als die erste und zweite Breite. Insbesondere ist die erste Breite größer als die zweite Breite. Beispielsweise kann die erste Breite etwa 6 mm und die zweite Breite etwa 4 mm betragen.

Die Vielzahl von ersten leitfähigen Bändern und die Vielzahl von zweiten leitfähigen Bändern sind stapelförmig bzw. zu einem Bandstapel mit kreuzförmigem Querschnitt angeordnet. Jeweils aufeinanderfolgende leitfähige Bänder des Bandstapels sind miteinander verbunden bzw. verlötet. Durch das Verlöten werden aufeinanderfolgende leitfähige Bänder insbesondere mechanisch und elektrisch miteinander verbunden. Unter Verlöten wird im Sinne dieser Beschreibung allgemein ein thermisches Verbinden, d.h. ein Verbinden durch Aufheizen, oder ein thermisches Verfahren zum stoffschlüssigen Fügen von Werkstoffen verstanden. Der verlötete Bandstapel wird im Sinne der vorliegenden Erfindung auch als Supraleiterkörper bezeichnet und bildet zumindest einen Teil des supraleitfähigen Leiters.

Der Supraleiterkörper bzw. der elektrische Leiter wird auf Grund des kreuzförmigen Querschnitts im Sinne der Erfindung auch als Kreuzleiter bzw. Cross-Conductor oder kurz CroCo bezeichnet. Mit Hilfe des erfindungsgemäßen Kreuzleiters kann vorteilhafterweise der äußere kreisförmige Querschnitt eines runden Leiters besser als in bisher realisierten Supraleiter-Stapel hergestellt werden. Gleichzeitig lässt sich der Kreuzleiter in einfacher Weise herstellen. Durch die Kreuzform wird die Querschnittsnutzung im Vergleich zu einem Bandstapel, welcher lediglich leitfähige Bänder bzw. Supraleiterbänder mit nur einer Breite aufweist, verbessert. Dadurch kann vorteilhafterweise die Stromdichte durch den Leiter erhöht werden.

Um den Querschnitt des Leiters möglichst gut auszunutzen, weist das Kreuz bzw. der kreuzförmige Querschnitt des Bandstapels bzw. des Supraleiterkörpers vorzugsweise eine nahezu vierzählige Symmetrie der äußeren Form auf.

Die Abmessungen des Kreuzes bzw. des kreuzförmigen Querschnittes senkrecht zu den Bandflächen der gestapelten leitfähigen Bänder bzw. Supraleiterbänder entsprechen vorzugsweise den Breiten der leitfähigen Bänder bzw. Supraleiterbänder. Insbesondere weist das Kreuz vier erste Kanten und acht zweite Kanten auf, wobei die Länge der vier ersten Kanten vorzugsweise jeweils im Wesentlichen der zweiten Breite der zweiten leitfähigen Bänder bzw. Supraleiterbänder entspricht und/oder wobei die Länge der acht zweiten Kanten vorzugsweise jeweils im Wesentlichen der Hälfte der Differenz aus erster Breite und zweiter Breite entspricht.

Vorzugsweise sind die erste und zweite Breite der leitfähigen Bänder bzw. Supraleiterbänder derart gewählt, dass für das Verhältnis aus der ersten Breite $b_1$ und der zweiten Breite $b_2$ gilt:

$$0,6 < b_2 / b_1 < 0,7 \quad (1).$$

Beispielsweise umfasst der supraleitfähige Leiter insgesamt 30 bis 36 leitfähigen Bänder bzw. Supraleiterbänder, wobei jedes eine Dicke von ca. 150 $\mu$m bis 165 $\mu$m aufweist. Dabei sind vorzugsweise zwei Drittel, d.h. etwa 20 bis 24 der Bänder, erste leitfähigen Bänder bzw. Supraleiterbänder mit einer ersten Breite und ein Drittel, d.h. etwa 10 bis 12 der Bänder, zweite leitfähigen Bänder bzw. Supraleiterbänder mit einer zweiten Breite.

In einer bevorzugten Ausführungsform besteht der Bandstapel, welcher den Supraleiterkörper bildet, nur bzw. ausschließlich aus Bändern mit zwei verschiedenen Breiten. Mit anderen Worten setzt sich der Bandstapel ausschließlich aus ersten leitfähigen Bändern mit der ersten Breite und zweiten leitfähigen Bändern mit der zweiten Breite zusammen. Mit anderen Worten umfasst der Bandstapel ausschließlich (abgesehen von z.B. der Lötpaste, welche die Bänder miteinander verbindet) erste leitfähige Bänder mit der ersten Breite und zweite leitfähige Bänder mit der zweiten Breite bzw. besteht der Bandstapel ausschließlich aus ersten leitfähigen Bändern mit der ersten Breite und zweiten leitfähigen Bändern mit der zweiten Breite. Der Bandstapel weist somit keine anderen als die ersten und zweiten leitfähigen Bänder auf. Mit anderen Worten weist der Bandstapel keine Bänder mit Breiten auf, die von der ersten und zweiten Breite abweichen.

In einer weiteren bevorzugten Ausführungsform umfasst bzw. besteht der Bandstapel bzw. der Supraleiterkörper aus einem mittleren Abschnitt und zwei Endabschnitten, wobei der mittlere Abschnitt unmittelbar zwischen den beiden Endabschnitten angeordnet ist und wobei der mittlere Abschnitt ausschließlich erste leitfähige Bänder bzw. Supraleiterbänder umfasst und die Endabschnitte jeweils ausschließlich zweite leitfähigen Bänder bzw. Supraleiterbänder umfassen.

Dass der mittlere Abschnitt unmittelbar zwischen den beiden Endabschnitten angeordnet ist, bedeutet, dass die Endabschnitte jeweils nahtlos, d.h. ohne weitere Zwischenabschnitte, an den mittleren Abschnitt angrenzen. Mit anderen Worten umfasst der Bandstapel bzw. der Supraleiterkörper keine weiteren Abschnitte als den mittleren Abschnitt und die beiden Endabschnitte.

Insbesondere weist der mittlere Abschnitt eine Vielzahl, beispielsweise zwanzig, erste leitfähigen Bänder bzw. Supraleiterbänder auf und jeder der beiden Endabschnitte eine Vielzahl, beispielsweise fünf, zweite leitfähigen Bänder bzw. Supraleiterbänder auf. Es versteht sich, dass die jeweilige Anzahl an ersten und zweiten leitfähigen Bändern bzw. Supraleiterbändern je nach Anwendung und/oder gewünschter Form des elektrischen Leiters gewählt sein kann. Vorzugsweise ist die zweite Breite der zweiten leitfähigen Bänder bzw. Supraleiterbänder, d.h. der leitfähigen Bänder bzw. Supraleiterbänder, welche in den Endabschnitten des Bandstapels bzw. des Supraleiterkörpers angeordnet sind, kleiner als die erste Breite der der ersten leitfähigen Bänder bzw. Supraleiterbänder, welche in dem mittleren Abschnitt des Bandstapels bzw. des Supraleiterkörpers angeordnet sind. Auf diese Weise ergibt sich der bereits oben beschriebene kreuzförmige Querschnitt des Bandstapels bzw. des Supraleiterkörpers. Zwar wäre es prinzipiell möglich, den Supraleiterkörper bzw. den elektrischen Leiter aus leitfähigen Bänder bzw. Supraleiterbändern mit mehr als zwei unterschiedlichen Breiten zu realisieren, wodurch eine noch bessere Querschnittsnutzung erreicht werden würde. Jedoch hat sich im Rahmen der vorliegenden Erfindung gezeigt, dass dies deutlich den Herstellungsaufwand erhöht und die Tordierbarkeit des Leiters beeinträchtigt. Der erfindungsgemäße Kreuzleiter, der genau zwei unterschiedliche leitfähigen Bänder bzw. Supraleiterbänder mit jeweils genau zwei unterschiedlichen Breiten aufweist, gewährleistet dagegen eine hohe Querschnittsnutzung bei gleichzeitig guter Tordierbarkeit und einem deutlich geringerem Herstellungsaufwand.

In einer bevorzugten Ausführungsform umfasst der supraleitfähige Leiter neben dem Supraleiterkörper ferner ein Hüllrohr. Insbesondere ist vorzugsweise der Supraleiterkörper von einem Hüllrohr umgeben. Die Art bzw. das Material des Hüllrohrs hängt insbesondere von der Anwendung ab.

Das Hüllrohr kann z.B. aus Kupfer oder Aluminium oder Messing oder Eisen oder einer Kombination oder Legierungen davon gebildet sein. Somit kann vorteilhafterweise eine zusätzliche Leitfähigkeit für den Quench-Fall bereitgestellt werden.

Alternativ oder zusätzlich kann das Hüllrohr auch aus Edelstahl oder ähnlichen Materialien gebildet sein. Dies verleiht dem supraleitfähigen Leiter eine besondere Stabilität.

Alternativ oder zusätzlich umfasst der supraleitfähige Leiter vorzugsweise ein oder mehrere leitfähige Formstücke, die zusammen mit dem Supraleiterkörper im Hüllrohr angeordnet sind. Damit kann der supraleitfähige Leiter trotz des kreuzförmigen Bandstapels in einfacher Weise im Wesentlichen kreisförmig gestaltet werden. Die Ausführung eines im Wesentlichen runden Leiters, d.h. eines Leiters mit im Wesentlichen kreisförmigem Querschnitt, hat den Vorteil der einfacheren Verwendbarkeit. Zudem kann der Supraleiterkörper durch die Formstücke geschützt und Hohlräume innerhalb des Hüllrohrs gefüllt werden.

Alternativ oder zusätzlich umfasst der supraleitfähige Leiter vorzugsweise ein oder mehrere Metalldrähte, insbesondere ist der Supraleiterkörper vorzugsweise mit einem oder mehreren Metalldrähten umhüllt bzw. umwickelt. Ist der Supraleiterkörper z.B. mit Drähten aus Kupfer, Aluminium, Messing oder einer Kombination aus Kupfer, Aluminium und Messing umwickelt, kann dadurch zusätzlich der Supraleiterkörper geschützt werden. Gleichzeitig kann die Umwicklung des Supraleiterkörpers mit Metalldrähten zur Leitfähigkeit im Quench-Fall beitragen, indem der Strom in einem solchen Fall über einem zusätzlichen Normalleiter fließen kann.

Alternativ oder zusätzlich umfasst der supraleitfähige Leiter vorzugsweise ein oder mehrere Stahldrähte. Ist der Supraleiterkörper mit Stahlbändern umwickelt, kann somit die Leitfähigkeit zwischen Supraleiterkörper und Hüllrohr vermindert werden.

Alternativ oder zusätzlich umfasst der supraleitfähige Leiter vorzugsweise ein Isoliermaterial. Ist der Supraleiterkörper mit Isolatormaterial, z.B. Kapton, umwickelt, so kann damit der Supraleiterkörper vom Hüllrohr isoliert werden.

In einer bevorzugten Ausführungsform weist der Bandstapel bzw. der Supraleiterkörper eine Verdrillung auf. Insbesondere sind die aufeinandergestapelten leitfähigen Bänder bzw. Supraleiterbänder miteinander verdrillt.

Eine Verdrillung des Bandstapels bzw. des Supraleiterkörpers ist vor allem dann wünschenswert, wenn durch den supraleitfähigen Leiter Ströme mit einem Wechselstrom-Anteil fließen sollen. Weiter ist eine Verdrillung vorteilhaft, falls der Leiter wie zum Beispiel beim Wickeln eines Magneten gebogen werden muss. In diesem Falle würde ohne Verdrillung ein außen liegendes Band des Leiters stark gedehnt und ein inneres Band des Leiters stark komprimiert werden. Wird der Leiter jedoch verdrillt, so wechseln sich Dehnung und Komprimierung zyklisch ab.

Ein weiterer unabhängiger Aspekt zur Lösung der Aufgabe betrifft eine Verwendung des erfindungsgemäßen supraleitfähigen Leiters zur Energie- bzw. Leistungsübertragung oder zur Erzeugung von Magnetfeldern.

Insbesondere kann der erfindungsgemäße supraleitfähige Leiter zur Übertragung von großen Strömen, z.B. im Bereich von 10 kA bis 100 kA oder mehr, z.B. von einem Kraftwerk zu einer Aluminiumschmelze, beim Anschluss eines Windparks an das Stromnetz oder bei der Fernübertragung von hohen elektrischen Leistungen, insbesondere in Bereichen, in denen lokale Freileitungen ungeeignet sind, verwendet werden. Auf Grund der hohen Ströme bzw. der hohen Stromdichten, die in dem erfindungsgemäßen supraleitfähigen Leiter fließen können, kann der erfindungsgemäße supraleitfähige Leiter zur Erzeugung hoher magnetischer Felder, beispielsweise für Teilchenbeschleuniger verwendet werden.

Alternativ kann der erfindungsgemäße supraleitfähige Leiter zum Ausbilden eines Kabels, das sich zur Energieübertragung und/oder zur Erzeugung von hohen Magnetfeldern eignet, verwendet werden.

Vorzugsweise wird ein Kabel aus einer Vielzahl der erfindungsgemäßen supraleitfähigen Leiter, insbesondere aus einem oder mehreren verdrillten Verbünden der supraleitfähigen Leiter, gebildet bzw. zusammengefügt. Somit lässt sich die Stromtragfähigkeit entsprechend der gewünschten Anwendung anpassen.

Vorzugsweise wird ein solches Bündel bzw. Kabel als Rundkabel ausgebildet. Dies hat den Vorteil, dass es bei der Verwendung keine explizit ausgewiesenen Vorzugsrichtungen aufgrund der äußeren Kabelform gibt.

Insbesondere kann für die Verwendung des erfindungsgemäßen supraleitfähigen Leiters zur Energieübertragung bzw. zur Erzeugung hoher Magnetfelder eine dem zu übertragenden Strom angepasste Anzahl an Leitern um ein zentrales Rohr oder eine geeignete Halterung angeordnet werden, so dass das Streufeld der einzelnen Leiter minimiert wird. Durch das Rohr kann vorzugsweise Kühlmittel gepumpt werden, um die Supraleiter zu kühlen.

Der erfindungsgemäße supraleitfähige Leiter kann auch zum Ausbilden eines gebogenen Kabels verwendet werden, indem der supraleitfähige Leiter zum Biegen des supraleitfähigen Leiters lokal, insbesondere auf bzw. über die Schmelztemperatur des in dem supraleitfähigen Leiter verwendeten Lotes bzw. Lötmittels, erwärmt wird. Das Lötmittel lässt im erwärmten Zustand vorteilhafterweise eine lokale Verschiebung der leitfähigen Bänder bzw. Supraleiterbänder untereinander zu.

Beispielsweise kann der supraleitfähige Leiter induktiv durch Wirbelströme oder durch Heißluft erwärmt werden, um beim Biegen wieder die Flexibilität der Supraleiter-Einzelbänder zu erhalten. Somit können Spannungen in den leitfähigen Bändern bzw. Supraleiterbändern beim Biegen weitgehend reduziert oder vermieden werden. Die Länge, über der das Lötmittel entlang des Leiters aufgeschmolzen wird, beträgt vorzugsweise mindestens eine Schlaglänge der Verdrillung des Supraleiterkörpers. Somit können vorteilhafterweise unterschiedliche Weglängen der Einzelbänder, die insbesondere auf Grund des Unterschieds in der Weglänge zwischen einer Innenseite und einer Außenseite des supraleitfähigen Leiters bei der Biegung auftreten, ausgeglichen werden.

Für den oben genannten weiteren unabhängigen Aspekt und insbesondere für diesbezügliche bevorzugte Ausführungsformen gelten auch die vor- oder nachstehend gemachten Ausführungen zu den Ausführungsformen des ersten Aspekts. Insbesondere gelten für einen unabhängigen Aspekt der vorliegenden Erfindung und für diesbezügliche bevorzugte Ausführungsformen auch die vor- und nachstehend gemachten Ausführungen zu den Ausführungsformen der jeweils anderen Aspekte.

Im Folgenden werden einzelne Ausführungsformen zur Lösung der Aufgabe anhand der Figuren beispielhaft beschrieben. Dabei weisen die einzelnen beschriebenen Ausführungsformen zum Teil Merkmale auf, die nicht zwingend erforderlich sind, um den beanspruchten Gegenstand auszuführen, die aber in bestimmten Anwendungsfällen gewünschte Eigenschaften bereit stellen. So sollen auch Ausführungsformen als unter die beschriebene technische Lehre fallend offenbart angesehen werden, die nicht alle Merkmale der im Folgenden beschriebenen Ausführungsformen aufweisen. Ferner werden, um unnötige Wiederholungen zu vermeiden, bestimmte Merkmale nur in Bezug auf einzelne der im Folgenden beschriebenen Ausführungsformen erwähnt. Es wird darauf hingewiesen, dass die einzelnen Ausführungsformen daher nicht nur für sich genommen sondern auch in einer Zusammenschau betrachtet werden sollen. Anhand dieser Zusammenschau wird der Fachmann erkennen, dass einzelne Ausführungsformen auch durch Einbeziehung von einzelnen oder mehreren Merkmalen anderer Ausführungsformen modifiziert werden können. Es wird darauf hingewiesen, dass eine systematische Kombination der einzelnen Ausführungsformen mit einzelnen oder mehreren Merkmalen, die in Bezug auf andere Ausführungsformen beschrieben werden, wünschenswert und sinnvoll sein kann, und daher in Erwägung gezogen und auch als von der Beschreibung umfasst angesehen werden soll.

Kurze Beschreibung der Zeichnungen

Figur 1         zeigt ein schematisches Bild des Querschnittes eines herkömmlichen supraleitfähigen Leiters mit gestapelten flachen Supraleiterbändern;

Figur 2a        zeigt ein schematisches Bild des Querschnittes eines erfindungsgemäßen supraleitfähigen Leiters gemäß eines ersten Beispiels;

Figur 2b        zeigt ein schematisches Bild des Querschnittes eines erfindungsgemäßen supraleitfähigen Leiters gemäß eines zweiten Beispiels;

Figur 3         zeigt eine schematische Skizze zu den Größenverhältnissen des kreuzförmigen Querschnitts eines supraleitfähigen Leiters gemäß einer bevorzugten Ausführungsform der vorliegenden Erfindung;

Figur 4a        zeigt ein schematisches Bild des Querschnittes eines erfindungsgemäßen supraleitfähigen Leiters gemäß einer Ausführungsform vor dem Kompaktieren;

Figur 4b        zeigt ein schematisches perspektivisches Bild des erfindungsgemäßen supraleitfähigen Leiters von Figur 4a;

Figur 5a        zeigt ein schematisches Bild des Querschnittes eines erfindungsgemäßen supraleitfähigen Leiters gemäß einer Ausführungsform nach dem Kompaktieren;

Figur 5b        zeigt ein schematisches perspektivisches Bild des erfindungsgemäßen supraleitfähigen Leiters von Figur 5a;

Figur 6a        zeigt ein schematisches Bild des Querschnittes eines erfindungsgemäßen supraleitfähigen Leiters gemäß einer weiteren Ausführungsform vor dem Kompaktieren;

Figur 6b        zeigt ein schematisches perspektivisches Bild des erfindungsgemäßen supraleitfähigen Leiters von Figur 6a;

Figur 7a        zeigt ein schematisches Bild des Querschnittes eines erfindungsgemäßen supraleitfähigen Leiters gemäß einer weiteren Ausführungsform nach dem Kompaktieren;

Figur 7b        zeigt ein schematisches perspektivisches Bild des erfindungsgemäßen supraleitfähigen Leiters von Figur 7a;

Figuren 8a-8d   zeigen schematische Bilder von unterschiedlichen Anordnungen eines oder mehrerer erfindungsgemäßen supraleitfähigen Leiter zum Ausbilden eines Verbundes bzw. Kabels;

Figur 9a      zeigt ein schematisches Bild eines supraleitfähigen Kabels gemäß einer bevorzugten Ausführungsform in einer perspektivischen Ansicht;

Figur 9b      zeigt ein schematisches Bild eines supraleitfähigen Kabels gemäß einer bevorzugten Ausführungsform in einer Querschnitts-Ansicht;

Figur 10a      zeigt eine schematische Zeichnung eines supraleitfähigen Leiters gemäß einer Ausführungsform ohne Verdrillung;

Figur 10b      zeigt eine schematische Zeichnung eines supraleitfähigen Leiters gemäß einer Ausführungsform mit Verdrillung;

## Detaillierte Beschreibung der Zeichnungen

Die in der vorliegenden Beschreibung gewählten Lageangaben, wie z. B. oben, unten, seitlich usw. sind jeweils auf die unmittelbar beschriebene sowie dargestellte Figur bezogen und sind bei einer Lageänderung sinngemäß auf die neue Lage zu übertragen.

Die **Figur 1** zeigt ein schematisches Bild des Querschnittes eines herkömmlichen supraleitfähigen Leiters. Der Leiter umfasst mehrere Supraleiterbänder 3, die jeweils dieselbe Breite aufweisen und aufeinandergestapelt sind. Der Querschnitt der aufeinandergestapelten Supraleiterbänder 3 ist quadratisch.

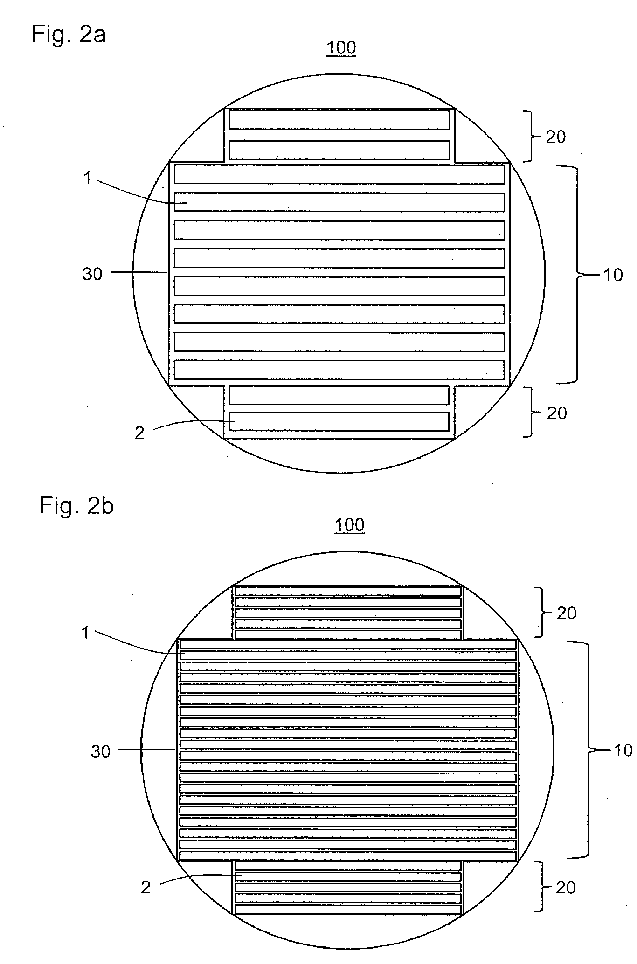

Die **Figuren 2a und 2b** zeigen jeweils ein schematisches Bild des Querschnittes eines erfindungsgemäßen supraleitfähigen Leiters 100. Die **Figuren 2a und 2b** unterscheiden sich lediglich in der Anzahl der verwendeten leitfähigen Bänder bzw. Supraleiterbänder.

Im Gegensatz zu dem herkömmlichen Leiter aus **Figur 1** umfasst der erfindungsgemäße Leiter 100 eine Vielzahl von ersten leitfähigen Bändern bzw. Supraleiterbändern 1 und eine Vielzahl von zweiten leitfähigen Bändern bzw. Supraleiterbändern 2. Die Vielzahl von ersten leitfähigen Bändern umfasst zumindest ein erstes Supraleiterband 1 und die Vielzahl von zweiten leitfähigen Bändern umfasst zumindest ein zweites Supraleiterband 2. Im Folgenden wird der Einfachheit halber und ohne Beschränkung der Allgemeinheit nur die Ausführungsform betrachtet, bei der sämtliche leitfähige Bänder Supraleiterbänder sind.

Die ersten Supraleiterbänder 1 weisen jeweils eine erste Breite und die zweiten Supraleiterbänder weisen jeweils eine zweite Breite auf, wobei die zweite Breite größer ist als die erste Breite. Der durch die Supraleiterbänder 1 und 2 gebildete Bandstapel 30 weist somit keinen quadratischen, sondern einen kreuzförmigen Querschnitt auf. Mit anderen Worten hat der Querschnitt des erfindungsgemäßen supraleitfähigen Leiters 100 die Form eines Kreuzes. Deshalb wird der erfindungsgemäße supraleitfähige Leiter 100 auch als Kreuzleiter oder Cross Conductor (kurz CroCo) bezeichnet.

Der Bandstapel 30 kann in drei Abschnitte eingeteilt werden, nämlich in einen mittleren Abschnitt 10 und zwei Endabschnitte 20. Der mittlere Abschnitt 10, welcher zwischen den beiden Endabschnitten 20 angeordnet ist, umfasst in der gezeigten Ausführungsform der **Figuren 2a und 2b** ausschließlich erste Supraleiterbänder 1 und die beiden Endabschnitte 20 umfassen ausschließlich zweite Supraleiterbänder 2.

Der erfindungsgemäße Kreuzleiter weist also Supraleiterbänder, insbesondere REBCO-Bänder, mit zwei unterschiedlichen Querschnitten bzw. Breiten auf. Somit kann der kreisförmige Querschnitt eines runden Leiters besser als in bisher realisierten Supraleiter-Stapeln ausgenutzt werden und gleichzeitig eine einfache Fertigung ermöglicht werden. Die Verwendung eines kreuzförmigen Supraleiter-Bandstapels anstelle eines quadratischen Supraleiter-Bandstapels bringt eine deutliche Verbesserung der Querschnittsnutzung. Während der geometrische Füllfaktor für den quadratischen Stapel aus der **Figur 1** nur 63,6% beträgt, beträgt der geometrische Füllfaktor im Falle des Bandstapels mit kreuzförmigem Querschnitt 78,4% (gerechnet für eine erste Breite von 6 mm und einer zweiten Breite von 4 mm). Durch die deutlich bessere Querschnittsausnutzung kann auch die Stromtragfähigkeit bzw. die Stromdichte des Leiters erhöht werden.

Zwar kann im Prinzip der geometrische Füllfaktor weiter erhöht werden, indem Supraleiterbänder mit mehr als zwei unterschiedlichen Breiten verwendet werden und ein Bandstapel erzeugt wird, dessen Querschnitt keine Kreuzform, sondern eine Mehrstufenform aufweist. Jedoch hat sich im Rahmen der Erfindung gezeigt, dass eine solche Mehrstufenform insbesondere im Hinblick auf die Tordierbarkeit des Leiters nachteilig sein kann. Vielmehr hat sich im Rahmen der Erfindung überraschenderweise herausgestellt, dass es vorteilhaft ist, für den Bandstapel lediglich Supraleiterbänder mit genau zwei unterschiedlichen Breiten zu verwenden, um damit einen kreuzförmigen Querschnitt des Bandstapels zu realisieren.

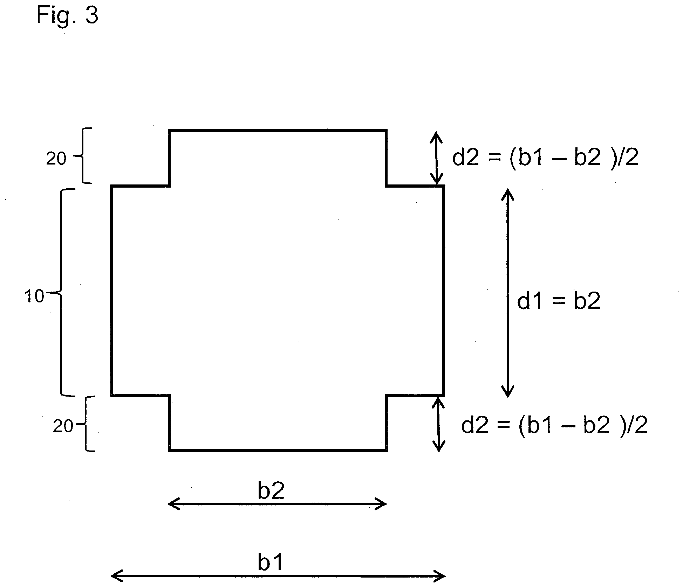

Die **Figur 3** zeigt eine schematische Skizze zu den Größenverhältnissen des kreuzförmigen Querschnitts eines erfindungsgemäßen supraleitfähigen Leiters gemäß einer bevorzugten Ausführungsform. Um den Querschnitt möglichst gut auszunutzen, weist das Kreuz vierzählige Symmetrie auf, d.h. die Abmessungen des Kreuzes senkrecht zu den Bandflächen entsprechen den Breiten der Bänder. Der mittlere Abschnitt 10 des Bandstapels weist folglich eine Höhe $d_1$ auf, die im Wesentlichen der Breite $b_2$ der zweiten Supraleiterbänder 2 entspricht. Die Endabschnitte 20 weisen jeweils eine Breite $d_2$ auf, die im Wesentlichen der Hälfte der Differenz zwischen der Breite $b_1$ der ersten Supraleiterbänder 1 und der Breite $b_2$ der zweiten Supraleiterbänder 2 entspricht. Die Endabschnitte weisen also im Wesentlichen eine Höhe von

$$d_2 = (b_1 - b_2)/2 \qquad (2)$$

auf.

Für

$$b_2 = \frac{\sqrt{5}-1}{2} b_1 \approx 0{,}618 \cdot b_1 \quad (3)$$

ist das Flächenverhältnis aus Kreuzfläche zu Umkreisfläche maximal. In diesem Fall ergibt sich eine maximale Flächenfüllung von 78,7 %. Von den derzeit kommerziell auf dem Markt erhältlichen und geeigneten Supraleiterbändern kann dieses ideale Verhältnis am besten durch $b_1$ = 6 mm und $b_2$ = 4 mm, also $b_2/b_1$ = 0,667, angenähert werden. Damit ergibt sich eine maximale Flächenfüllung von 78,4 %, was nahezu dem theoretischen Maximum entspricht.

Ist die Breite $b_1$ der ersten Supraleiterbänder 6 mm und die Breite $b_2$ der zweiten Supraleiterbänder 4 mm, so ergibt sich für die Anzahl $N_1$ der ersten Supraleiterbänder in dem mittlerer Abschnitt 10 und die Anzahl $N_2$ der zweiten Supraleiterbänder in einem der Endabschnitte 20:

$$N_1 = 4 \text{ mm} / 0{,}165 \text{ mm} \approx 24 \qquad (4),$$

$$N_2 = (6 \text{ mm} - 4 \text{ mm}) / 0{,}165 \text{ mm} \approx 12 \qquad (5),$$

wenn 0,165 mm die Dicke der Supraleiterbänder ist. Die Dicke der Lotschicht wurde hierbei nicht berücksichtigt.

Beispielsweise können insgesamt 30 bis 36 Bänder, wobei jedes eine Stärke von ca. 150 bis 165 $\mu$m aufweist, für den Bandstapel verwendet werden. Dabei sind vorzugsweise zwei Drittel (also 20 bis 24) der Bänder 6 mm breit und ein Drittel der Bänder (also 10 bis 12) 4 mm breit. Unter Berücksichtigung der Dicke der Lotschichten zwischen den einzelnen Bändern ergibt sich damit eine Stärke des Kreuzleiters von etwa 5,5 mm bis 6,2 mm, also eine fast vierzählige Symmetrie der äußeren Form.

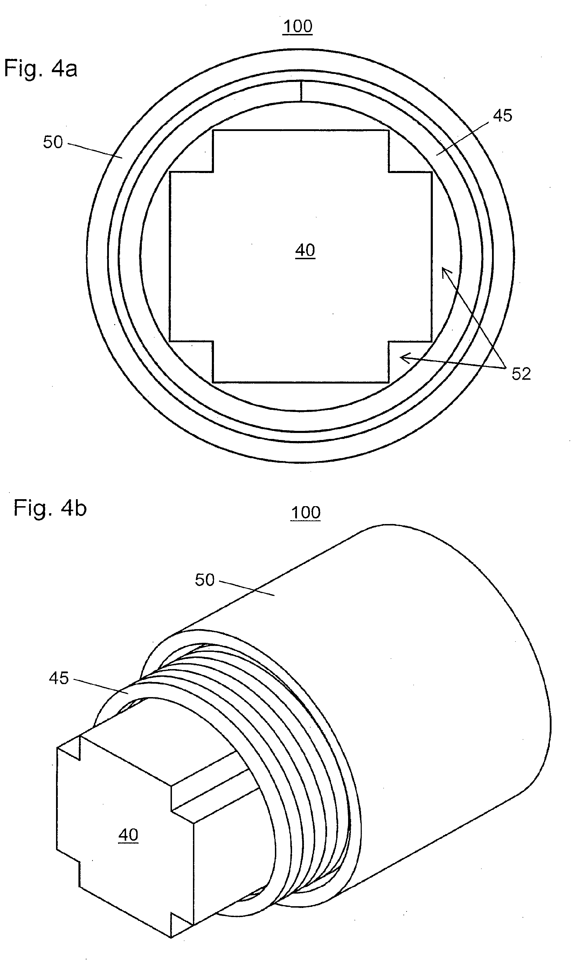

Die **Figuren 4a und 4b** zeigen jeweils ein schematisches Bild des Querschnittes eines erfindungsgemäßen supraleitfähigen Leiters 100 gemäß einer bevorzugten Ausführungsform, bevor der Leiter kompaktiert wurde. Dabei wurden zunächst der kreuzförmige Bandstapel bzw. die einzelnen Supraleiterbänder des Bandstapels zu einem Supraleiterkörper 40 verlötet und in ein rundes Hüllrohr 50 eingeführt, wobei der Supraleiterkörper 40 vor dem Einführen in das Hüllrohr 50 noch mit einem Lötdraht 45 umwickelt wurde.

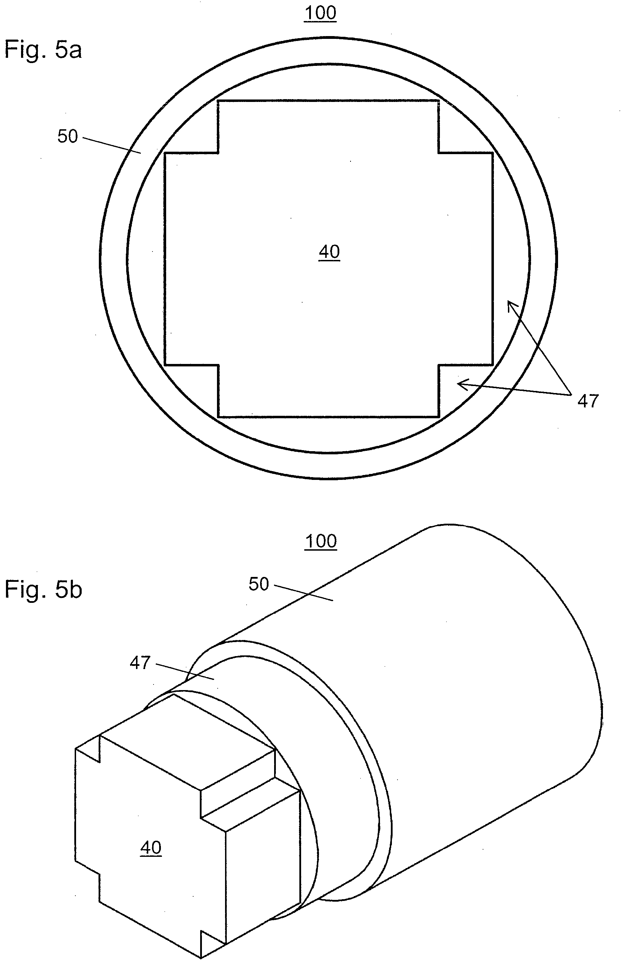

Die **Figuren 5a und 5b** zeigen jeweils ein schematisches Bild des supraleitfähigen Leiters 100, nachdem dieser über die Schmelztemperatur des Lötbandes 45 erwärmt und mit geeigneten Methoden, wie z.B. einem Rundkneten und/oder Ziehen, kompaktiert wurde. Wie in der **Figur 5a** und der perspektivischen Ansicht der **Figur 5b** zu erkennen ist, ist aus dem Lötdraht 45 der **Figur 4a bzw. 4b** durch das Erwärmen und/oder Kompaktieren eine ausgedehnte Lotschicht 47 zwischen Supraleiterkörper 40 und Hüllrohr 50 geworden.

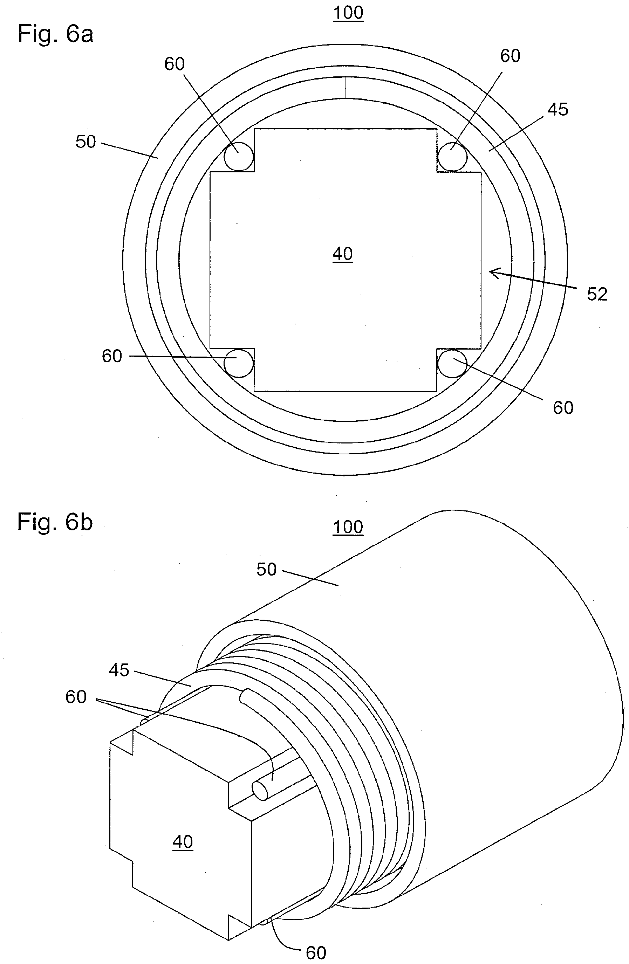

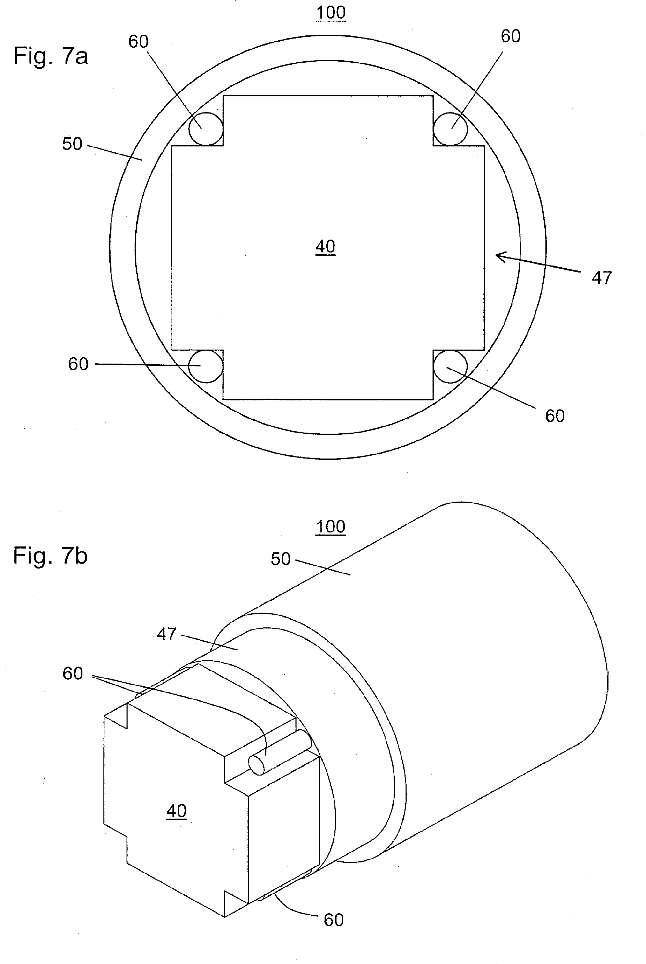

Die **Figuren 6a, 6b, 7a und 7b** entsprechen jeweils den **Figuren 4a, 4b, 5a und 5b** mit dem Unterschied, dass der supraleitfähige Leiter 100 in der Ausführungsform der **Figuren 6a, 6b, 7a und 7b** zusätzliche Formstücke 60 umfasst, die zusammen mit dem Supraleiterkörper 40 in dem Hüllrohr 50 angeordnet bzw. in das Hüllrohr 50 eingeführt sind. Auf diese Weise kann die Stabilität erhöht und Lötmittel eingespart werden.

Alternativ oder zusätzlich zu dem Lötdraht 45 kann der Supraleiterkörper 40 mit anderen bzw. weiteren Drähten oder Bänder, z.B. mit Metalldrähten aus Kupfer, Aluminium und/oder Messing, oder mit Stahldrähten, umwickelt sein. Solche zusätzlichen Drähte können die Stabilität und/oder die Leitfähigkeit, insbesondere in einem Quench-Fall, sicherstellen bzw. erhöhen.

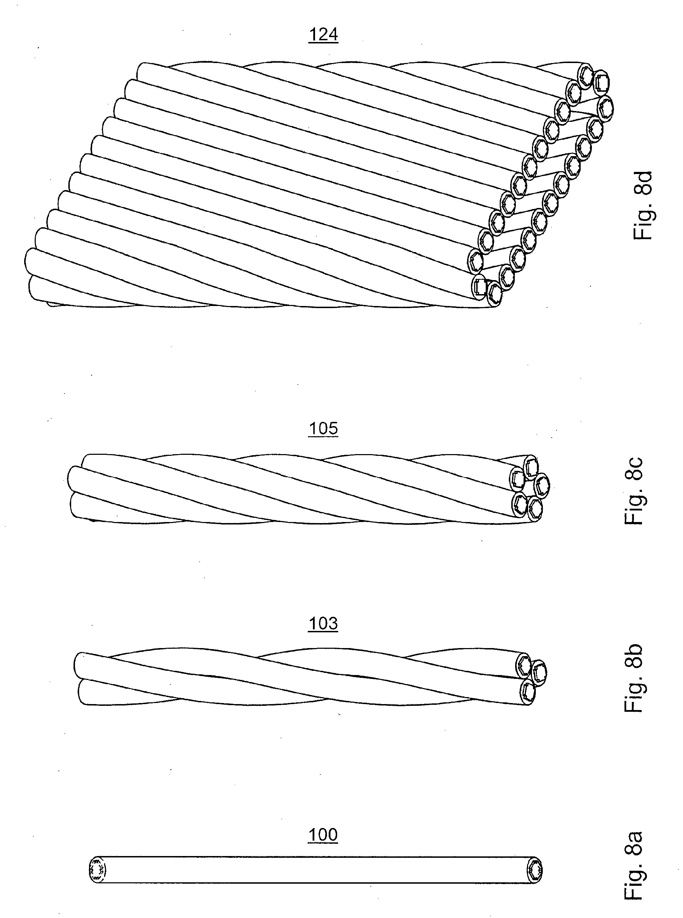

Die **Figuren 8a bis 8d** zeigen schematische Bilder von unterschiedlichen Anordnungen eines oder mehrerer erfindungsgemäßen supraleitfähigen Leiter 100 zum Ausbilden eines Verbundes bzw. Kabels. Der erfindungsgemäße Kreuzleiter 100 kann, wie in der **Figur 8a** dargestellt, einzeln oder, wie in den **Figuren 8b bis 8d** dargestellt, als Kabel, insbesondere in verdrillten Verbünden benutzt werden, um die Stromtragfähigkeit je nach Anwendung zu erhöhen. In der **Figur 8b** ist beispielsweise ein Kabel 103 mit drei supraleitfähigen miteinander verdrillten Leitern 100 dargestellt, in der **Figur 8c** ist ein Kabel 105 mit fünf supraleitfähigen miteinander verdrillten Leitern 100 dargestellt und in der **Figur 8d** ist ein Kabel 124 mit 24 supraleitfähigen miteinander verdrillten Leitern 100 dargestellt.

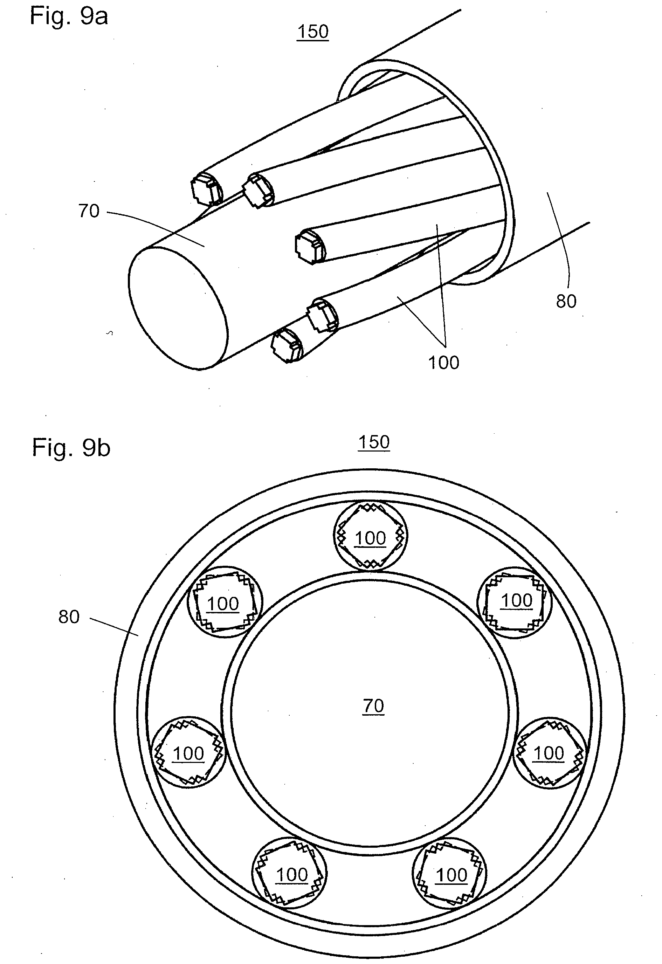

Wie in den **Figuren 9a und 9b** anhand eines Kabels 150 dargestellt, kann für die Anwendung des supraleitfähigen Leiters 100 zur Energieübertragung eine dem zu übertragenden Strom angepasste Anzahl an Leitern 100 um ein zentrales Rohr 70 oder einer geeigneten Halterung angeordnet werden, so dass das Streufeld der einzelnen Leiter 100 minimiert wird. Durch das Rohr 70 kann Kühlmittel gepumpt werden, um die Supraleiter zu kühlen. Zudem umfasst das in den **Figuren 9a und 9b** dargestellte Kabel 150 einen Schutzmantel 80, der vorzugsweise elektrisch isolierend ist.

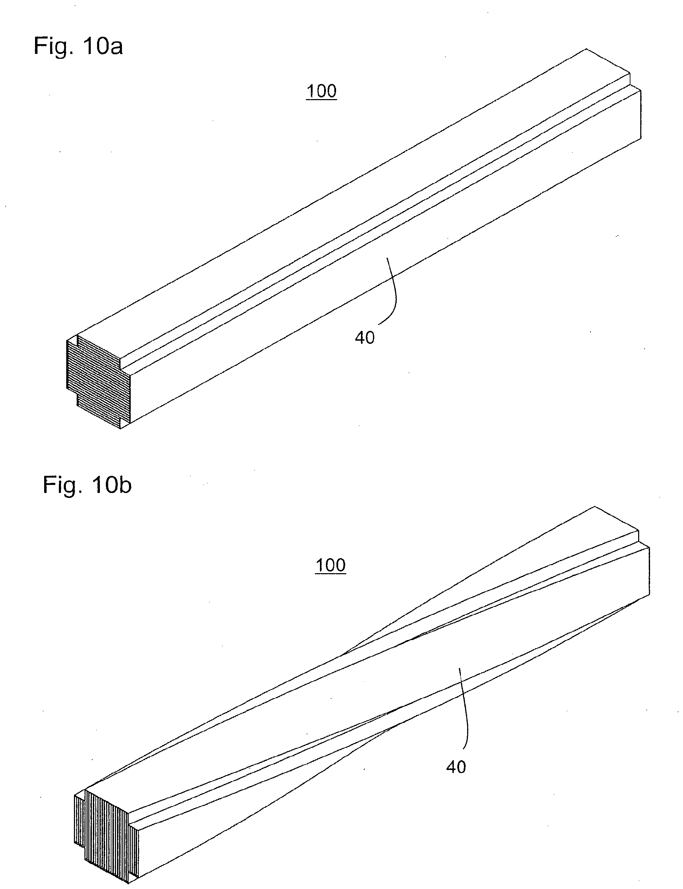

Die **Figur 10a** zeigt eine schematische Zeichnung eines supraleitfähigen Leiters 100 ohne Verdrillung, während in der **Figur 10b** eine schematische Zeichnung eines supraleitfähigen Leiters 100 mit Verdrillung gezeigt ist.

Der erfindungsgemäße supraleitfähige Leiter 100 weist neben hohen Stromdichten auch eine gute Stromverteilung sowie geringe Strom-Einkopplungslängen durch das gleichmäßige und zuverlässige Verlöten der Supraleiterbänder bzw. des Bandstapels in dem Lötbad auf. Durchgeführte Belastungs- bzw. Zugtests bei einer Temperatur von 4.2 K und einem Magnetfeld von 12 T zeigten, dass der erfindungsgemäße Kreuzleiter erst bei Belastungswerten zu degradieren beginnt, die mit denen der einzelnen Supraleiterbänder vergleichbar sind.

**Bezugszeichenliste**

| | |
|---|---|
| 1 | Erstes leitfähiges Band bzw. Supraleiterband mit einer ersten Breite |
| 2 | Zweites leitfähiges Band bzw. Supraleiterband mit einer zweiten Breite |
| 3 | Supraleiterband |
| 10 | Mittlerer Abschnitt |
| 20 | Endabschnitt |
| 30 | Bandstapel aus leitfähigen Bändern bzw. Supraleiterbändern |
| 40 | Supraleiterkörper |
| 45 | Lötdraht / Lötband |
| 47 | Lotschicht |
| 50 | Hüllrohr |
| 52 | Freiräume |
| 60 | Formstück |
| 70 | Rohr |
| 80 | Schutzmantel |
| 100 | Supraleitfähiger Leiter |
| 103 | Bündel von supraleitfähigen Leitern / Kabel |
| 105 | Bündel von supraleitfähigen Leitern / Kabel |
| 124 | Bündel von supraleitfähigen Leitern / Kabel |
| 150 | Bündel von supraleitfähigen Leitern / Kabel |

**Patentansprüche**

**1.** Supraleitfähiger Leiter (100), umfassend:

- eine Vielzahl von ersten leitfähigen Bändern (1), welche jeweils eine erste Breite aufweisen; und
- eine Vielzahl von zweiten leitfähigen Bändern (2), welche jeweils eine zweite Breite aufweisen;

wobei sich die erste Breite von der zweiten Breite unterscheidet,

wobei die Vielzahl von ersten leitfähigen Bändern (1) und/oder die Vielzahl von zweiten leitfähigen Bändern (2) zumindest ein Supraleiterband umfasst,
wobei die Vielzahl von ersten leitfähigen Bändern (1) und die Vielzahl von zweiten leitfähigen Bändern (2) zu einem Bandstapel (30) mit kreuzförmigem Querschnitt angeordnet sind, und
wobei jeweils zwei in dem Bandstapel (30) aufeinanderfolgende leitfähige Bänder miteinander verlötet sind, so dass aus dem Bandstapel (30) ein Supraleiterkörper (40) gebildet ist.

2. Supraleitfähiger Leiter (100) nach Anspruch 1, wobei der Bandstapel (30) nur aus Bändern mit zwei verschiedenen Breiten besteht.

3. Supraleitfähiger Leiter (100) nach Anspruch 1 oder 2, wobei der Bandstapel (30) ausschließlich erste leitfähige Bänder (1) mit der ersten Breite und zweite leitfähige Bänder (2) mit der zweiten Breite umfasst.

4. Supraleitfähiger Leiter (100) nach Anspruch 1, wobei der Bandstapel (30) aus einem mittleren Abschnitt (10) und zwei Endabschnitten (20) besteht, wobei der mittlere Abschnitt (10) unmittelbar zwischen den beiden Endabschnitten (20) angeordnet ist und wobei der mittlere Abschnitt (10) ausschließlich erste leitfähige Bänder (1) umfasst und die Endabschnitte (20) jeweils ausschließlich zweite leitfähige Bänder (2) umfassen.

5. Supraleitfähiger Leiter (100) nach einem der vorangehenden Ansprüche, ferner umfassend:

   - ein Hüllrohr (50) und/oder
   - ein oder mehrere leitfähige Formstücke (60) und/oder
   - ein oder mehrere Metalldrähte und/oder
   - ein oder mehrere Stahldrähte und/oder
   - Isoliermaterial.

6. Supraleitfähiger Leiter (100) nach einem der vorangehenden Ansprüche, wobei der Supraleiterkörper (40) eine Verdrillung aufweist.

7. Verwendung des supraleitfähigen Leiters (100) nach einem der vorangehenden Ansprüche zur Energieübertragung oder zur Erzeugung von Magnetfeldern oder zum Ausbilden eines Kabels (103; 105; 124; 150), das sich zur Energieübertragung und/oder zur Erzeugung von Magnetfeldern eignet.

8. Verwendung nach Anspruch 7, wobei der supraleitfähige Leiter (100) zum Ausbilden eines Kabels (103; 105; 124; 150) verwendet wird und das Kabel (103; 105; 124; 150) aus einer Vielzahl der supraleitfähigen Leiter (100), insbesondere aus einem oder mehreren verdrillten Verbünden der supraleitfähigen Leiter (100), gebildet wird.

9. Verwendung nach Anspruch 7 oder 8, wobei der supraleitfähige Leiter (100) zum Ausbilden eines gebogenen Kabels lokal, insbesondere auf oder über die Schmelztemperatur des in dem supraleitfähigen Leiter (100) verwendeten Lötmittels, erwärmt wird.

**Claims**

1. A superconductive conductor (100), comprising:

   - a plurality of first conductive tapes (1) each having a first width; and
   - a plurality of second conductive tapes (2) each having a second width;

   wherein the first width differs from the second width,

   wherein the plurality of first conductive tapes (1) and/or the plurality of second conductive tapes (2) comprises at least one superconductor tape,
   wherein the plurality of first conductive tapes (1) and the plurality of second conductive tapes (2) are arranged to form a tape stack (30) having a cross-shaped cross-section, and
   wherein respectively two consecutive conductive tapes in tape stack (30) are soldered to one another, so that a superconductor body (40) is formed from the tape stack (30).

2. The superconductive conductor (100) according to claim 1, wherein the tape stack (30) consists only of tapes of two different widths.

3. The superconductive conductor (100) according to claim 1 or 2, wherein the tape stack (30) exclusively comprises first conductive tapes (1) of the first width and second conductive tapes (2) of the second width.

4. The superconductive conductor (100) according to claim 1, wherein the tape stack (30) consists of a middle portion (10) and two end portion (20), the middle portion (10) being arranged immediately between the two end portions (20), and the middle portion (10) comprising exclusively first conductive tapes (1), and the end portions (20) each comprising exclusively second conductive tapes (2).

5. The superconductive conductor (100) according to one of the preceding claims, further comprising:

   - a cladding tube (50) and/or
   - one or more conductive shaped parts (60) and/or
   - one or more metal wires and/or
   - one or more steel wires and/or
   - insulating material.

6. The superconductive conductor (100) according to one of the preceding claims, wherein the superconductor body (40) has a twist.

7. A use of the superconductive conductor (100) according to one of the preceding claims for energy transmission or for generating magnetic fields or for forming a cable (103; 105; 124; 150) suitable for energy transmission and/or for generating magnetic fields.

8. The use according to claim 7, wherein the superconductive conductor (100) is used to form a cable (103; 105; 124; 150), and the cable (103; 105; 124; 150) is formed of a plurality of the superconductive conductors (100), in particular of one or more twisted groupings of the superconductive conductors (100).

9. The use according to claim 7 or 8, wherein the superconductive conductor (100) is locally heated, in particular at or above the melting temperature of the solder used in the superconductive conductor (100), to form a bent cable.


**Revendications**

1. Un conducteur supraconducteur (100) comprenant :

   - une pluralité de premières bandes conductrices (1), chacune présentant une première largeur ; et
   - une pluralité de deuxièmes bandes conductrices (2), chacune présentant une deuxième largeur ;

   sachant que la première largeur est différente de la deuxième largeur,

   sachant que la pluralité de premières bandes conductrices (1) et/ou la pluralité de deuxièmes bandes conductrices (2) comprend au moins une bande supraconductrice,
   sachant que la pluralité de premières bandes conductrices (1) et la pluralité de deuxièmes bandes conductrices (2) sont agencées en un empilement de bandes (30) présentant une section transversale en forme de croix, et sachant que respectivement deux bandes conductrices se succédant dans l'empilement de bandes (30) étant soudées entre elles, de manière qu'un corps supraconducteur (40) est formé à partir de l'empilement de bandes (30).

2. Le conducteur supraconducteur (100) d'après la revendication 1, sachant que l'empilement de bandes (30) est constitué uniquement de bandes de deux largeurs différentes.

3. Le conducteur supraconducteur (100) d'après la revendication 1 ou 2, sachant que l'empilement de bandes (30) comprend uniquement des premières bandes conductrices (1) de la première largeur et des deuxièmes bandes conductrices (2) de la deuxième largeur.

4. Le conducteur supraconducteur (100) d'après la revendication 1, sachant que l'empilement de bandes (30) est constitué d'une portion centrale (10) et de deux portions d'extrémité (20), sachant que la portion centrale (10) est agencée directement entre les deux portions d'extrémité (20), et sachant que la portion centrale (10) comprend uniquement des premières bandes conductrices (1) et que les portions d'extrémité (20) comprennent chacune uniquement des deuxièmes bandes conductrices (2).

5. Le conducteur supraconducteur (100) d'après l'une quelconque des revendications précédentes, comprenant en outre :

   - un tube de gainage (50) et/ou
   - une ou plusieurs pièces façonnées conductrices (60) et/ou
   - un ou plusieurs fils métalliques et/ou
   - un ou plusieurs fils d'acier et/ou
   - un matériau isolant.

6. Le conducteur supraconducteur (100) d'après l'une quelconque des revendications précédentes, sachant que le corps supraconducteur (40) présente un torsadage.

7. Une utilisation du conducteur supraconducteur (100) d'après l'une quelconque des revendications précédentes pour la transmission d'énergie ou la génération de champs magnétiques ou pour former un câble (103 ; 105 ; 124 ; 150) apte à la transmission d'énergie et/ou à la génération de champs magnétiques.

8. L'utilisation d'après la revendication 7, sachant que le conducteur supraconducteur (100) est utilisé pour former un câble (103 ; 105 ; 124 ; 150) et que le câble (103 ; 105 ; 124 ; 150) est constitué d'une pluralité des conducteurs supraconducteurs (100), notamment d'un ou plusieurs ensembles torsadés des conducteurs supraconducteurs (100).

9. L'utilisation d'après la revendication 7 ou 8, sachant que le conducteur supraconducteur (100) est chauffé localement, notamment à ou au-dessus de la température de fusion du matériau d'apport de soudure utilisé dans le conducteur supraconducteur (100), pour former un câble courbé.

Fig. 1

Stand der Technik

Fig. 2a

Fig. 2b

Fig. 3

$d2 = (b1 - b2)/2$

$d1 = b2$

$d2 = (b1 - b2)/2$

b2

b1

Fig. 4a

100

50

45

40

52

Fig. 4b

100

50

45

40

100

Fig. 5a

50

40

47

100

Fig. 5b

50

47

40

Fig. 6a

100

60

60

50

45

40

52

60

60

Fig. 6b

100

50

45

60

40

60

Fig. 7a

Fig. 7b

124

Fig. 8d

105

Fig. 8c

103

Fig. 8b

100

Fig. 8a

Fig. 9a

150

70

80

100

Fig. 9b

150

100

100

100

80

70

100

100

100

100

Fig. 10a

100

40

Fig. 10b

100

40

**IN DER BESCHREIBUNG AUFGEFÜHRTE DOKUMENTE**

**In der Beschreibung aufgeführte Patentdokumente**

- US 20100099570 A1
- JP H09223418 A
- US 2010099570 A1
- US 5929000 A
- US 6271474 B1